# EUROPEAN PATENT APPLICATION

(11) **EP 4 565 019 A1**
(43) Date of publication of application: **04.06.2025**
(21) Application number: 22955306.0
(22) Date of filing: 17.08.2022
(51) Int. Cl.: H05K 7/20, H01L 23/367, H01L 23/373

(54) **THERMALLY CONDUCTIVE STRUCTURE, ELECTRONIC DEVICE, AND TERMINAL**

(71) Applicant: Shenzhen Yinwang Intelligent Technologies Co., Ltd., Shenzhen, Guangdong 518129 (CN)
(72) Inventor: FU, Sanfu, Shenzhen, Guangdong 518129 (CN)
(74) Representative: Gill Jennings & Every LLP
(86) International application number: PCT/CN2022/113134
(87) International publication number: WO 2024/036525

(57) **Abstract**

This application provides a thermally conductive structure, an electronic device, and a terminal. The thermally conductive structure includes a thermally conductive part and an insulating ring. An upper side and a lower side of the thermally conductive part are at least partially exposed, so that the thermally conductive part can be in contact with a heating component and a heat sink on the two sides to conduct heat. The insulating ring may protect the thermally conductive part around a periphery of the thermally conductive part. When the thermally conductive structure is aged or damaged, the internal thermally conductive part is not likely to fall off. Therefore, the thermally conductive part may be disposed as a thermally conductive part of a high thermally conductive material, and may be specifically a thermally conductive part made of an electrically conductive material. **In** this way, a thermal conduction capability of the thermally conductive structure is improved, and a risk of a short circuit is not likely to be caused. When the thermally conductive structure is specifically disposed, the insulating ring is an enclosed ring, or the insulating ring is provided with an opening.

## Description

### TECHNICAL FIELD

This application relates to the field of heat dissipation structure technologies, and in particular, to a thermally conductive structure, an electronic device, and a terminal.

### BACKGROUND

With development of electronic technologies, a computing capability of a chip is continuously improved, power consumption is greatly increased, and a size of the chip develops toward miniaturization. In this case, the chip generates an increasing amount of heat, and a density of the heat is increasingly high, which pose a relatively high challenge to a heat dissipation capability of the chip.

In a conventional technology, a heat sink is usually used to dissipate heat for the chip. To ensure that the heat of the chip is efficiently conducted to the heat sink, a thermally conductive layer needs to be disposed between the heat sink and the chip. A thermal conduction capability of the thermally conductive layer has relatively important impact on the heat dissipation capability of the chip. In addition, structural reliability of the thermally conductive layer is also relatively important, so that the thermally conductive layer can be relatively reliable and not likely to be damaged when an electronic device vibrates or another case occurs.

### SUMMARY

This application provides a thermally conductive structure, an electronic device, and a terminal. An insulating ring protects a thermally conductive part, so that the thermally conductive part may be made of a thermally conductive material, to improve thermal conduction efficiency of the thermally conductive structure.

According to a first aspect, this application provides a thermally conductive structure. The thermally conductive structure includes a thermally conductive part and an insulating ring. The thermally conductive part is located in the insulating ring. An upper side and a lower side of the thermally conductive part are at least partially exposed, so that the thermally conductive part can be in contact with a heating component and a heat sink on the two sides to conduct heat. The insulating ring may protect the thermally conductive part around a periphery of the thermally conductive part. When the thermally conductive structure is aged or damaged, aging or damage mainly occurs on the insulating ring, and the internal thermally conductive part is not likely to fall off. Therefore, the thermally conductive part may be disposed as a thermally conductive part of a high thermally conductive material, that is, may be a thermally conductive part made of an electrically conductive material. In this way, a thermal conduction capability of the thermally conductive structure is improved, and a risk of a short circuit is not likely to be caused. In a specific technical solution, the insulating ring is an enclosed ring, or the insulating ring is provided with an opening. The insulating ring may be the enclosed ring, and is disposed completely around the thermally conductive part. In this solution, the insulating ring is disposed completely around the thermally conductive part. In this way, the thermally conductive part is not likely to expose from the insulating ring. This helps improve reliability of the thermally conductive structure. Alternatively, the insulating ring may be provided with the opening. After the thermally conductive structure is installed in an electronic device, the opening of the insulating ring may absorb deformation, so that the insulating ring is not likely to wrinkle or be pulled. Specifically, there may be one or more openings.

When the thermally conductive structure is specifically disposed, the thermally conductive structure includes a first side and a second side that are opposite to each other. On the first side of the thermally conductive structure, a surface of the thermally conductive part and a surface of the insulating ring are in a same plane. On the second side of the thermally conductive structure, a surface of the thermally conductive part and a surface of the insulating ring are in a same plane. In other words, a thickness of the thermally conductive part and a thickness of the insulating ring are the same, and both the two sides of the thermally conductive structure are planes. This solution is applicable to a scenario in which one side of the heat sink is a plane and one side of the heating component is also a plane.

In another technical solution, on the first side of the thermally conductive structure, the thermally conductive part and a surface of the insulating ring are in a same plane. On the second side of a thermally conductive layer, the insulating ring protrudes from a surface of the thermally conductive part. In this embodiment, the thermally conductive structure is applicable to a case in which one side of the heating component is not a plane, or a case in which one side of the heat sink is not a plane. Even if a structure on one side is not the plane, it can be ensured that the thermally conductive part is sealed by using the insulating ring, to protect the thermally conductive part and reduce a risk of a short circuit.

In still another technical solution, on the first side of the thermally conductive structure, the insulating ring protrudes from a surface of the thermally conductive part. On the second side of a thermally conductive layer, the insulating ring protrudes from a surface of the thermally conductive part. This solution is mainly applicable to a case in which one side of the heating component is not a plane and one side of the heat sink is neither a plane. This solution can also ensure that the thermally conductive part is sealed by using the insulating ring, to protect the thermally conductive part and reduce a risk of a short circuit.

When the insulating ring and the thermally conductive part are specifically provided, the insulating ring may be fastened to the thermally conductive part. In other words, the thermally conductive part and the insulating ring are separately manufactured and then fastened. In a specific technical solution, the insulating ring and the thermally conductive part may be fastened and bonded through bonding.

In another technical solution, the insulating ring and the thermally conductive part are of an integrated structure. In this solution, reliability of a connection between the insulating ring and the thermally conductive part can be improved, so that the thermally conductive part is not likely to be damaged.

In still another technical solution, there is a gap between the insulating ring and the thermally conductive part. This solution may absorb deformation of the thermally conductive part and the insulating ring, or may be configured to adapt to a specific structure of the electronic device. In addition, the thermally conductive part and the insulating ring may be two independent components, and are separately manufactured, transported, and installed.

When the insulating ring is specifically manufactured, a material of the insulating ring may be at least one of foam, rubber, or sealant. Costs are relatively low and manufacture is convenient.

Alternatively, the insulating ring may be made of a thermally conductive material, and the thermally conductive material is specifically an insulating material. In this solution, a thermally conductive area of the thermally conductive structure can be improved. This helps improve thermal conduction efficiency and a thermal conduction capability of the thermally conductive structure.

When the insulating ring is made of the thermally conductive material, a material of the insulating ring may specifically include a thermally conductive gel, a thermally conductive insulating tape, a thermally conductive adhesive, or a thermally conductive insulating film. A thermally conductive coefficient of the thermally conductive material may be less than that of the thermally conductive part, but still has specific thermal conductivity.

Specifically, the thermally conductive coefficient of the thermally conductive part is greater than or equal to 10 W/(m·K). Specifically, the thermally conductive coefficient of the thermally conductive part may alternatively be greater than or equal to 30 W/(m·K). In this case, the thermal conduction efficiency of the thermally conductive structure can be improved.

A specific material of the thermally conductive part includes carbon fiber or graphene.

In addition, both a shape of the thermally conductive part and a shape of the insulating ring are not limited. In a specific technical solution, an edge shape of the thermally conductive part may be the same as an inner edge shape of the insulating ring. In this solution, cooperation between the thermally conductive part and the insulating ring can be improved. Optionally, the shape may be any possible shape such as a triangle, a square, a polygon, a circle, an ellipse, or an abnormal shape.

According to a second aspect, this application further provides an electronic device. The electronic device includes a heating component, a heat sink, and the thermally conductive structure in the first aspect. The thermally conductive structure is disposed between the heating component and the heat sink, and is configured to conduct heat of the heating component to the heat sink. The thermally conductive structure in this solution has relatively high thermal conduction efficiency and relatively high reliability, and can reduce a risk of a short circuit.

When the thermally conductive structure is specifically disposed, one side of an insulating ring is disposed in contact with the heating component, and the other side is disposed in contact with the heat sink. In this way, the thermally conductive part is enclosed among the heating component, the insulating ring, and the heat sink, so that the thermally conductive part is not likely to fall into a circuit region of the electronic device when the thermally conductive part ages or is damaged. Therefore, a risk of a short circuit is reduced.

In another technical solution, if the heating component is disposed on a circuit board, one side of the insulating ring may be disposed in contact with the circuit board, and the other side of the insulating ring may be disposed in contact with the heat sink. In this solution, the thermally conductive part is enclosed among the circuit board, the insulating ring, and the heat sink, so that the thermally conductive part is not likely to fall into a circuit region of the electronic device when the thermally conductive part ages or is damaged. Therefore, a risk of a short circuit is reduced.

In a specific technical solution, the electronic device is a vehicle-mounted electronic device. Vibration or the like easily occurs in a running process of a vehicle, but the thermally conductive structure in this solution is not likely to fall off in a vibration scenario. Therefore, heat dissipation efficiency of the vehicle-mounted electronic device can be effectively improved.

According to a third aspect, this application further provides a terminal. The terminal includes the electronic device in the second aspect. The terminal has a relatively strong heat dissipation capability and a relatively good operating status.

### BRIEF DESCRIPTION OF DRAWINGS

FIG. 1 is a schematic diagram of a top-view structure of a thermally conductive structure according to an embodiment of this application;
FIG. 2 is a schematic diagram of a sectional-view structure of a thermally conductive structure according to an embodiment of this application;
FIG. 3 is a schematic diagram of another top-view structure of a thermally conductive structure according to an embodiment of this application;
FIG. 4 is a schematic diagram of another top-view structure of a thermally conductive structure according to an embodiment of this application;
FIG. 5 is a schematic diagram of another top-view structure of a thermally conductive structure according to an embodiment of this application;
FIG. 6 is a schematic diagram of another top-view structure of a thermally conductive structure according to an embodiment of this application;
FIG. 7 is a schematic diagram of another top-view structure of a thermally conductive structure according to an embodiment of this application;
FIG. 8 is a schematic diagram of another top-view structure of a thermally conductive structure according to an embodiment of this application;
FIG. 9 is a schematic diagram of another top-view structure of a thermally conductive structure according to an embodiment of this application;
FIG. 10 is a schematic diagram of another top-view structure of a thermally conductive structure according to an embodiment of this application;
FIG. 11 is a schematic diagram of a structure of an electronic device according to an embodiment of this application;
FIG. 12 is a schematic diagram of another sectional-view structure of a thermally conductive structure according to an embodiment of this application;
FIG. 13 is a schematic diagram of another structure of an electronic device according to an embodiment of this application;
FIG. 14 is a schematic diagram of another sectional-view structure of a thermally conductive structure according to an embodiment of this application; and
FIG. 15 is a schematic diagram of another structure of an electronic device according to an embodiment of this application.

### Reference numerals:

1: thermally conductive structure;
11: thermally conductive part;
12: insulating ring;
121: opening;
13: gap;
14: first side;
15: second side;
2: heating component;
21: second protrusion;
3: heat sink;
31: first protrusion;
4: circuit board.

### DESCRIPTION OF EMBODIMENTS

Terms used in the following embodiments are merely intended to describe specific embodiments, but are not intended to limit this application. Terms "one", "a", "the", "the foregoing", "this", and "the one" of singular forms used in this specification and the appended claims of this application are also intended to include expressions such as "one and more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements "in one embodiment", "in some embodiments", "in some other embodiments", "in other embodiments", and the like that appear at different places in this specification do not necessarily mean reference to a same embodiment. Instead, the statements mean "one or more but not all of embodiments", unless otherwise specifically emphasized in another manner. Terms "include", "comprise", "have", and variants thereof all mean "including but not limited to", unless otherwise specifically specified in another manner.

To facilitate understanding of a foldable terminal provided in embodiments of this application, the following first describes an application scenario of the foldable terminal. With the development of electronic technologies, a requirement for heat dissipation of heating components such as a chip is increasingly obvious. In a conventional technology, heat dissipation of the heating component is usually implemented by using a heat sink. To ensure heat dissipation effect, a thermally conductive structure needs to be disposed between the heating component and the heat sink. The thermally conductive structure has thermal conductivity, and may conduct heat of the heating component to the heat sink for heat dissipation. In addition, the thermally conductive structure is usually flexible, so that a relatively reliable contact between the heating component and the heat sink can be achieved, and a contact area is increased, to improve the heat dissipation effect of the heating component. A material of the thermally conductive structure includes an insulation material and an electrically conductive material. A thermally conductive structure with relatively good thermal conductivity is usually a thermally conductive structure of the electrically conductive material. However, the heating component such as the chip is usually used in an electrical structure such as a circuit board. Therefore, in some scenarios, if the thermally conductive structure is of the electrically conductive material, a short circuit is likely to occur. Especially, in scenarios in which a vibration is severe and the thermally conductive structure is used for a long time, the thermally conductive structure is easily damaged. A part of a thermally conductive structure that is damaged is likely to fall off, and a thermally conductive structure that falls off falls on a circuit structure such as the circuit board. In this case, the short circuit is likely to be caused. Therefore, this application provides a thermally conductive structure and an electronic device.

To make objectives, technical solutions, and advantages of this application clearer, the following further describes this application in detail with reference to the accompanying drawings.

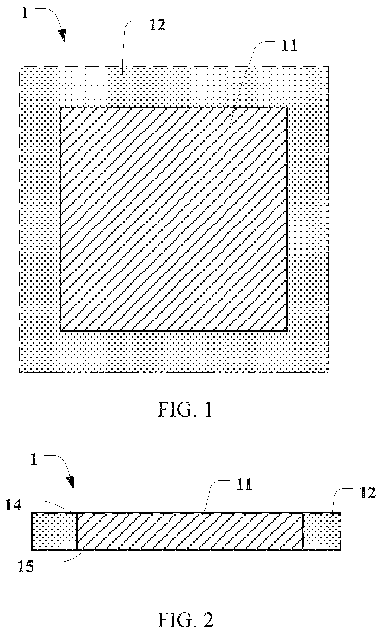

FIG. 1 is a schematic diagram of a top-view structure of a thermally conductive structure according to an embodiment of this application. FIG. 2 is a schematic diagram of a sectional-view structure of a thermally conductive structure according to an embodiment of this application. Refer to FIG. 1 and FIG. 2. The thermally conductive structure 1 in this embodiment of this application includes a thermally conductive part 11 and an insulating ring 12. The thermally conductive part 11 is located in the insulating ring 12. To be specific, the insulating ring 12 is disposed around a periphery of the thermally conductive part 11, and an upper side and a lower side of the thermally conductive part 11 are at least partially exposed. In this way, the thermally conductive part 11 can be in contact with a heating component and a heat sink on the two sides to conduct heat. The upper side and the lower side of the thermally conductive part 11 are separately a side that is of the thermally conductive part 11 and that is in contact with the heating component and a side that is of the thermally conductive part 11 and that is in contact with the heat sink. In this embodiment, the periphery of the thermally conductive part 11 is protected by the insulating ring 12. Even if the thermally conductive structure 1 is aged or damaged, aging or damage mainly occurs on the insulating ring 12, and the internal thermally conductive part 11 is not likely to fall off. Therefore, the thermally conductive part 11 may be disposed as a thermally conductive part 11 of a high thermally conductive material, and may be a thermally conductive part 11 made of an electrically conductive material. In this way, a thermal conduction capability of the thermally conductive structure 1 is improved, and a risk of a short circuit is not likely to be caused.

In a specific embodiment, an anti-aging capability of the insulating ring 12 may be stronger than an anti-aging capability of the thermally conductive part 11. In this way, when the thermally conductive part 11 ages, the insulating ring 12 experiences a relatively low degree of aging and is not likely to be damaged, so that protection effect for the thermally conductive part 11 is relatively good. In addition, mechanical strength of the insulating ring 12 may be further greater than mechanical strength of the thermally conductive part 11. In this way, the insulating ring 12 is not likely to be damaged in a vibration process. Therefore, in this solution, an antivibration capability of the thermally conductive structure 1 is relatively good.

In a specific embodiment, a material of the insulating ring 12 may be at least one of foam, rubber, and sealant. The materials are flexible and easy to install. In addition, the materials are easy to fabricate and costs are relatively low.

In another specific embodiment, the insulating ring 12 may alternatively be made of a thermally conductive material. The thermally conductive material has specific thermal conductivity. Certainly, the thermal conductivity of the thermally conductive material may be lower than thermal conductivity of the thermally conductive part 11. Therefore, the insulating ring 12 may also conduct heat, to increase a thermally conductive area of the thermally conductive structure 1, and improve thermally conductive effect of the thermally conductive structure 1. For example, the thermally conductive material may be a thermally conductive gel, a thermally conductive insulating tape, a thermally conductive adhesive, or a thermally conductive insulating film. The thermally conductive adhesive may be formed through heat curing or room temperature curing. In other words, the thermally conductive adhesive may be a heat-curing thermally conductive adhesive or a room temperature-curing thermally conductive adhesive. In addition, the insulating ring 12 may alternatively be made of the thermally conductive gel or the like.

Specifically, the thermally conductive part 11 may be made of the electrically conductive material, and therefore has relatively good thermal conductivity. For example, a thermally conductive coefficient of the thermally conductive part 11 is greater than or equal to 10 W/(m·K). The thermally conductive coefficient is heat transferred through an area of one square meter within a specific time period for a one-meter (m)-thick material with a temperature difference of one degree (K or °C) on surfaces of two sides under a stable heat transfer condition. The thermally conductive coefficient is in a unit of watt/meter·degree (W/(m·K)). K may be replaced with °C herein. For example, the thermally conductive coefficient of the thermally conductive part 11 may be 11 W/(m·K), 15 W/(m·K), 18 W/(m·K), 20 W/(m·K), 22 W/(m·K), 25 W/(m·K), 26 W/(m·K), 30 W/(m·K), 35 W/(m·K), 40 W/(m·K), or the like. This is not listed one by one herein. For example, a material of the thermally conductive part 11 includes carbon fiber or graphene. Thermal conduction capabilities of the two materials are relatively strong. This helps improve the thermal conduction capability of the thermally conductive structure 1.

Still refer to FIG. 1. When the insulating ring 12 is specifically disposed, the insulating ring 12 may be an enclosed ring. In other words, the insulating ring 12 is not provided with an opening 121, and is disposed completely around the thermally conductive part 11. In this solution, the insulating ring 12 is disposed completely around the thermally conductive part 11. In this way, the thermally conductive part 11 is not likely to expose from the insulating ring 12. This helps improve reliability of the thermally conductive structure 1. In addition, the insulating ring 12 is of an integral structure and is easy to install.

In a specific embodiment, the insulating ring 12 may be of an integrated structure. In other words, the enclosed ring is manufactured through a one-step forming process. In this embodiment, a manufacturing process of the insulating ring 12 is simplified, and overall strength of the insulating ring 12 is relatively high.

Alternatively, in another specific embodiment, the insulating ring 12 may form the enclosed ring through a fixed connection such as bonding. In conclusion, a manner of forming the enclosed ring is not limited in this application, provided that the enclosed ring can be formed.

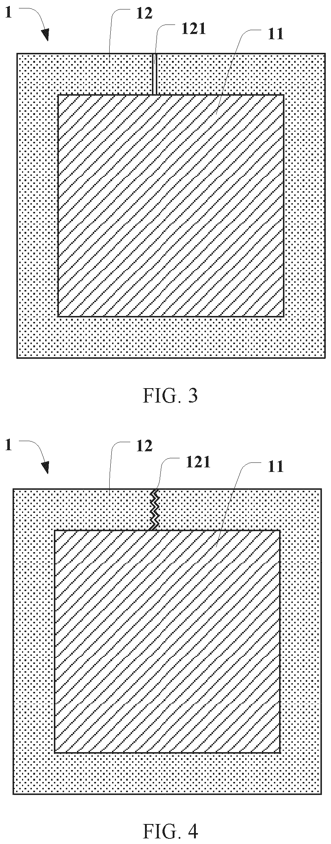

FIG. 3 is a schematic diagram of another top-view structure of a thermally conductive structure according to an embodiment of this application. As shown in FIG. 3, in another embodiment, the insulating ring 12 is further provided with an opening 121. In this embodiment, after the thermally conductive structure 1 is installed in an electronic device, the opening of the insulating ring 12 may absorb deformation, so that the insulating ring 12 is not likely to wrinkle or be pulled.

A size of the opening is not limited. For example, a width of the opening may range from 0 millimeters to 5 millimeters. In other words, the width of the opening may range from 0 mm to 5 mm. In an embodiment, the opening 121 is merely a gap. In other words, the insulating ring 12 is not connected to form an enclosed ring.

When the opening 121 is specifically provided, an edge shape of the opening 121 is not limited. As shown in FIG. 3, the edge of the opening 121 may be of a straight line shape. Alternatively, FIG. 4 is a schematic diagram of another top-view structure of a thermally conductive structure according to an embodiment of this application. As shown in FIG. 4, in another embodiment, the edge of the opening 121 may alternatively be of a zigzag shape. In this solution, when the opening 121 is provided, a risk of exposure of the internal thermally conductive part 11 is further reduced, and reliability of the thermally conductive structure 1 is improved. In addition, the edge of the opening 121 may alternatively be of an arc shape, a wave shape, or the like. This is not listed one by one herein.

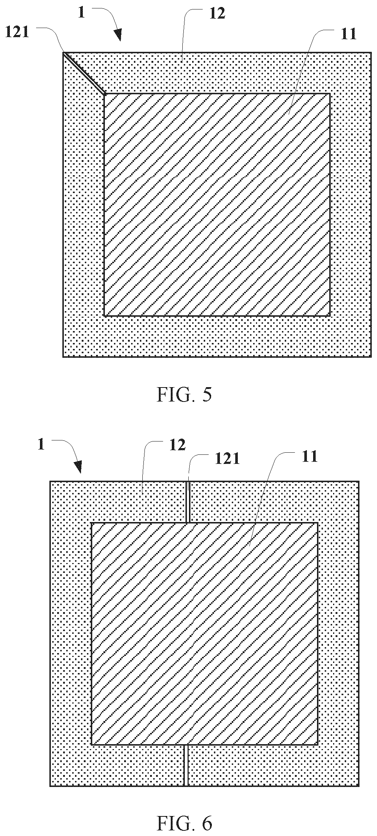

When the opening 121 is specifically provided, a specific position of the opening 121 is not limited either. An example in which a shape of the thermally conductive structure 1 is a square. As shown in FIG. 3 or FIG. 4, in an embodiment, the opening 121 may be disposed at a position of a side of the thermally conductive structure 1. FIG. 5 is a schematic diagram of another top-view structure of a thermally conductive structure according to an embodiment of this application. As shown in FIG. 5, in another embodiment, the opening 121 may be alternatively disposed at a diagonal position of the thermally conductive structure 1.

In addition, in a specific embodiment, a quantity of the openings 121 included in the insulating ring 12 is not limited either. As shown in FIG. 3 to FIG. 5, in an embodiment, the insulating ring 12 may include one opening 121. FIG. 6 is a schematic diagram of another top-view structure of a thermally conductive structure according to an embodiment of this application. As shown in FIG. 6, in another embodiment, the insulating ring 12 may alternatively include two openings 121, and the two openings 121 may be disposed on two opposite sides. Certainly, in other embodiments, the insulating ring 12 may alternatively be provided with a plurality of openings 121, for example, three, four, or more openings 121.

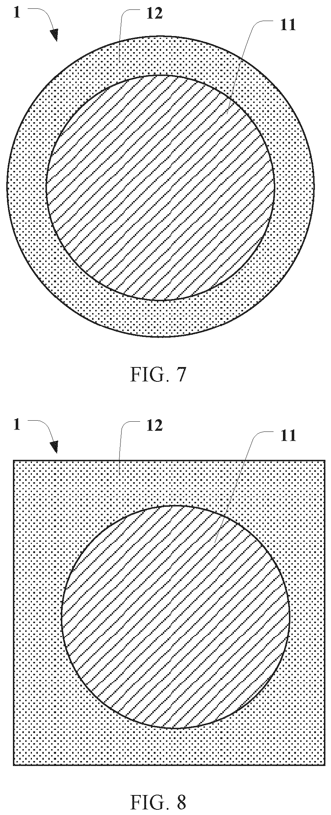

In a specific embodiment, the specific shape of the thermally conductive structure 1 is not limited. In an embodiment, an edge shape of the thermally conductive part 11, an inner edge shape of the insulating ring 12, and an outer edge shape of the insulating ring 12 are the same. However, each of the edge shapes is not limited. In an embodiment, as shown in FIG. 6, each of the edges is a square. In another embodiment, as shown in FIG. 7, each of the edges is a circle.

Alternatively, FIG. 8 is a schematic diagram of another top-view structure of a thermally conductive structure according to an embodiment of this application. As shown in FIG. 8, in another embodiment, only the edge shape of the thermally conductive part 11 and the inner edge shape of the insulating ring 12 are the same, and the outer edge shape of the insulating ring 12 may be different from the shapes. In the embodiment shown in FIG. 8, both the edge shape of the thermally conductive part 11 and the inner edge shape of the insulating ring 12 are circles, and the outer edge shape of the insulating ring 12 is a square. In this embodiment, a relatively reliable connection between the thermally conductive part 11 and the insulating ring 12 can be achieved, and the insulating ring 12 protects the thermally conductive part 11, so that the thermally conductive part 11 is not likely to expose from the insulating ring 12.

In a specific embodiment, the shapes of the thermally conductive part 11 and the insulating ring 12 may be designed based on a shape and an installation position of a heating component. This is not listed one by one in this application.

In a specific embodiment, as shown in FIG. 1 to FIG. 8, the insulating ring 12 of the thermally conductive structure 1 is fastened to the thermally conductive part 11. For example, the insulating ring 12 may be fastened to the thermal conduction through adhesive bonding or interference fit assembly. In this solution, the thermally conductive structure 1 may be of an integrated structure, so that transportation and installation of the thermally conductive structure 1 is facilitated.

Alternatively, in another embodiment, the insulating ring 12 and the thermally conductive part 11 may further be of an integrated structure. In other words, the thermally conductive structure 1 is manufactured through a one-step forming process. In this solution, the insulating ring 12 and the thermally conductive part 11 are relatively reliably fastened, so that reliability of the thermally conductive structure 1 is improved, and the thermally conductive part 11 is not likely to expose from insulation.

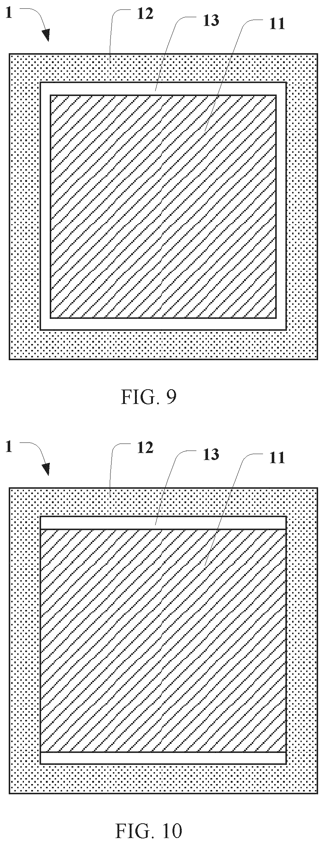

FIG. 9 is a schematic diagram of another top-view structure of a thermally conductive structure according to an embodiment of this application. As shown in FIG. 9, in another embodiment, there is further a gap 13 between a thermally conductive part 11 and an insulating ring 12. A specific width of the gap 13 is not limited, for example, may range from 0 mm to 5 mm. This solution may absorb deformation of the thermally conductive part 11 and the insulating ring 12, or may be configured to adapt to a specific structure of an electronic device. In this embodiment, the thermally conductive part 11 and the insulating ring 12 may be two independent components, and are separately manufactured, transported, and installed.

FIG. 10 is a schematic diagram of another top-view structure of a thermally conductive structure according to an embodiment of this application. As shown in FIG. 10, in an optional design, the gap 13 may be configured to be not completely surrounding the thermally conductive part 11. For example, when an outer edge shape of the thermally conductive part 11 is a quadrilateral, the gap 13 is disposed at a position of any one side, any two sides, or any three sides, and a closed annular gap. For example, in the embodiment shown in FIG. 10, the gap 13 is located at two opposite sides of the thermally conductive part 11 of a quadrilateral shape. In this solution, the gap 13 may be used to absorb the deformation of the thermally conductive part 11 and the insulating ring 12, and the thermally conductive part 11 and the insulating ring 12 may be further fastened, so that installation and transportation of the thermally conductive structure is facilitated.

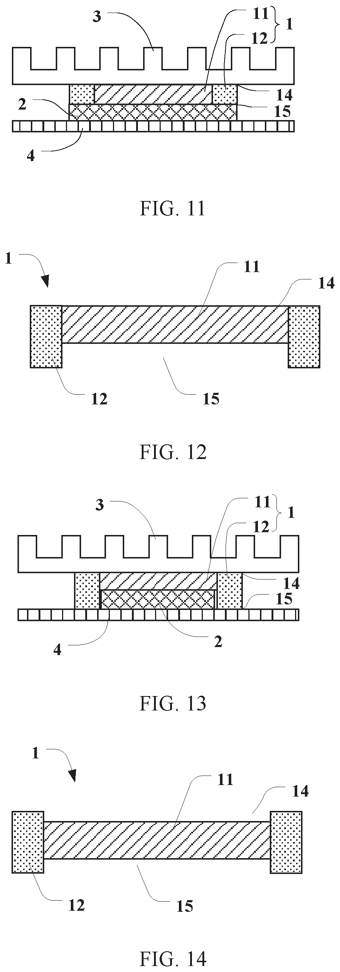

Based on a same inventive concept, this application further provides an electronic device. Specifically, FIG. 11 is a schematic diagram of a structure of an electronic device according to an embodiment of this application. As shown in FIG. 11, the electronic device includes a heating component 2, a heat sink 3, and the thermally conductive structure 1 in any one of the foregoing embodiments. The thermally conductive structure 1 is disposed between the heating component 2 and the heat sink 3, and specifically, two sides of the thermally conductive part 11 may be respectively in contact with the heating component 2 and heat dissipation, to transmit heat between the heating component 2 and the heat dissipation. A thermal conduction capability of the thermally conductive structure 1 in this embodiment is relatively strong. Therefore, a heat dissipation capability of the electronic device is relatively strong. In addition, the thermally conductive structure 1 is not likely to cause a short circuit of the electronic device, and helps improve reliability of the electronic device.

In a specific embodiment, as shown in FIG. 11, one side of the insulating ring 12 is in contact with the heating component 2, and the other side is disposed in contact with the heat sink 3. In this solution, the thermally conductive part 11 is sealed among the heating component 2, the heat sink 3, and the insulating ring 12, so that a probability that the thermally conductive part 11 is exposed to the outside may be effectively reduced, and structure reliability of the electronic device is improved.

Refer to FIG. 2 and FIG. 11. In a specific embodiment, the thermally conductive structure 1 includes a first side 14 and a second side 15 that are opposite to each other. The thermally conductive structure 1 is specifically a sheet-shaped structure. Along a direction perpendicular to a surface of the thermally conductive part 11, the thermally conductive structure 1 includes the first side 14 and the second side 15 that are opposite to each other. On the first side 14 of the thermally conductive structure 1, a surface of the thermally conductive part 11 and a surface of the insulating ring 12 are in a same plane. On the second side 15 of a thermally conductive layer, the thermally conductive part 11 and a surface of the insulating ring 12 are in a same plane. A manufacturing process of the thermally conductive structure 1 in this solution is relatively simple. This helps simplify the manufacturing process of the thermally conductive structure 1. In addition, storage and transportation of the thermally conductive structure 1 is further facilitated. This solution is mainly applicable to a case in which one side of the heating component 2 is a planar structure and one side of the heat sink 3 is also a planar structure.

FIG. 12 is a schematic diagram of another sectional-view structure of a thermally conductive structure according to an embodiment of this application. As shown in FIG. 12, in another embodiment, on a first side 14 of the thermally conductive structure 1, a thermally conductive part 11 and a surface of an insulating ring 12 are in a same plane. On a second side 15 of the thermally conductive structure 1, the insulating ring 12 protrudes from a surface of the thermally conductive part 11. In this embodiment, the thermally conductive structure 1 is applicable to a case in which one side of a heating component 2 is not a plane, or a case in which one side of a heat sink 3 is not a plane. This solution is mainly applicable to a case in which one side of the heating component 2 is a planar structure and one side of the heat sink 3 is provided with a first protrusion 31, a case in which one side of the heating component 2 is provided with a second protrusion 21 and one side of the heat sink 3 is a planar structure, or a case in which the heating component 2 is disposed on a circuit board 4, the heating component 2 protrudes from the circuit board 4, and one side of the heat sink 3 is a planar structure.

FIG. 13 is a schematic diagram of another structure of an electronic device according to an embodiment of this application. As shown in FIG. 13, in another embodiment, the heating component 2 is disposed on the circuit board 4, the heating component 2 protrudes from the circuit board 4. In this case, the heating component 2 is equivalent to the second protrusion 21. In this case, the thermally conductive structure 1 may be shown in FIG. 12. On the second side 15 of the thermally conductive structure 1, the insulating ring 12 protrudes from the thermally conductive part 11, so that the second side 15 of the thermally conductive structure 1 faces one side of the circuit board 4. Specifically, on the first side 14 of the thermally conductive structure 1, both the thermally conductive part 11 and the insulating ring 12 are disposed in contact with the heat sink 3. On the second side 15 of the thermally conductive structure 1, the thermally conductive part 11 is disposed in contact with the heating component 2, and the insulating ring 12 is disposed in contact with the circuit board 4. In this solution, the thermally conductive part 11 may also be sealed among the heat sink 3, the circuit board 4, and the insulating ring 12, so that the thermally conductive part 11 is not likely to expose.

Certainly, when the thermally conductive structure 1 in the embodiment shown in FIG. 11 is used in the electronic device, the thermally conductive structure 1 may alternatively be shown in FIG. 11. In this embodiment, the insulating ring 12 has specific elasticity, and is compressed between the heating component 2 and the heat sink 3. This solution helps improve reliability of protecting the thermally conductive part 11 by the insulating ring 12.

FIG. 14 is a schematic diagram of another sectional-view structure of a thermally conductive structure according to an embodiment of this application. As shown in FIG. 14, in another embodiment, on a first side 14 of the thermally conductive structure 1, an insulating ring 12 protrudes from a surface of a thermally conductive part 11. On a second side 15 of a thermally conductive layer, the insulating ring 12 protrudes from a surface of the thermally conductive part 11. In this embodiment, the thermally conductive structure 1 may be adapted to a shape of one side of a heating component 2 or a shape of one side of a heat sink 3. This solution is mainly applicable to a case in which one side of the heating component 2 is provided with a second protrusion 21 and one side of the heat sink 3 is provided with a first protrusion 31, or a case in which the heating component 2 is disposed on a circuit board 4, the heating component 2 protrudes from the circuit board 4, and one side of the heat sink 3 is a planar structure.

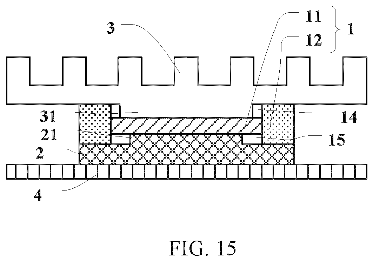

FIG. 15 is a schematic diagram of another structure of an electronic device according to an embodiment of this application. As shown in FIG. 15, in another embodiment, the heating component 2 is disposed on the circuit board 4, and the heating component 2 is provided with the second protrusion 21. In addition, the heat sink 3 is provided with a first protrusion 31. The thermally conductive structure 1 in this embodiment is shown in FIG. 14. When the thermally conductive structure 1 is disposed between the heating component 2 and the heat sink 3, the first side 14 of the thermally conductive structure 1 faces one side of the heat sink 3, the thermally conductive part 11 is disposed in contact with the first protrusion 31 of the heat sink 3, and the insulating ring 12 is disposed in contact with the heat sink 3 at a position where the first protrusion 31 is not provided on the heat sink 3. The second side 15 of the thermally conductive structure 1 is disposed facing the heating component 2, the thermally conductive part 11 is disposed in contact with the heating component 2, and the insulating ring 12 is disposed in contact with the circuit board 4. In this solution, the thermally conductive part 11 may also be sealed among the heat sink 3, the circuit board 4, and the insulating ring 12, so that the thermally conductive part 11 is not likely to expose.

Certainly, when the thermally conductive structure 1 in the embodiment shown in FIG. 14 is used in the electronic device, the thermally conductive structure 1 may alternatively be shown in FIG. 11. In this embodiment, the insulating ring 12 has specific elasticity, and is compressed between the heating component 2 and the heat sink 3. This solution helps improve reliability of protecting the thermally conductive part 11 by the insulating ring 12.

It should be noted that "disposed in contact with" in embodiments of this application may include direct contact or indirect contact, and mainly indicates that there is no gap between two objects. For example, if A is disposed in contact with B, A and B may be in direct contact, or a transition component C may alternatively be disposed between A and B. To be specific, A is in direct contact with C, and C is in direct contact with B. In this case, there is no gap between A and B.

In embodiments shown in FIG. 12 and FIG. 14, a thickness of the insulating ring 12 is greater than a thickness of the thermally conductive layer. In this case, strength of the insulating ring 12 is relatively high, and both an anti-shock capability and an anti-aging capability are relatively strong. This solution helps improve a service life and reliability of the thermally conductive structure 1.

In a specific embodiment, the heating component 2 may be a chip. This is not specifically limited in this application. The electronic device may be a vehicle-mounted electronic device. Vibration or the like easily occurs in a running process of a vehicle. In embodiments of this application, the insulating ring 12 may protect the thermally conductive part 11. Therefore. A scenario in which the vibration is severe may be better adapted. This helps improve heat dissipation performance of the vehicle-mounted electronic device of the vehicle, and a service life, performance, and the like of the vehicle-mounted electronic device are further improved.

This application further provides a terminal. The terminal includes the foregoing electronic device. A specific type of the terminal is not limited. For example, the terminal may be a communication terminal such as a server or a memory, may be a mobile terminal such as a notebook computer or a tablet computer, or may be another terminal such as a vehicle or a home device. The terminal has a relatively strong heat dissipation capability, and therefore has a relatively good operating capability.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A thermally conductive structure, comprising a thermally conductive part and an insulating ring, wherein the thermally conductive part is located in the insulating ring, and the insulating ring is an enclosed ring, or the insulating ring is provided with an opening.

2. The thermally conductive structure according to claim 1, wherein the thermally conductive structure comprises a first side and a second side that are opposite to each other, on the first side of the thermally conductive structure, a surface of the thermally conductive part and a surface of the insulating ring are in a same plane, and on the second side of the thermally conductive structure, a surface of the thermally conductive part and a surface of the insulating ring are in a same plane.

3. The thermally conductive structure according to claim 1, wherein the thermally conductive structure comprises a first side and a second side that are opposite to each other, on the first side of the thermally conductive structure, a surface of the thermally conductive part and a surface of the insulating ring are in a same plane, and on the second side of the thermally conductive structure, the insulating ring protrudes from the thermally conductive part.

4. The thermally conductive structure according to claim 1, wherein the thermally conductive structure comprises a first side and a second side that are opposite to each other, on the first side of the thermally conductive structure, the insulating ring protrudes from the thermally conductive part, and on the second side of the thermally conductive structure, the insulating ring protrudes from the thermally conductive part.

5. The thermally conductive structure according to any one of claims 1 to 4, wherein the insulating ring is fastened to the thermally conductive part.

6. The thermally conductive structure according to any one of claims 1 to 4, wherein the insulating ring and the thermally conductive part are of an integrated structure.

7. The thermally conductive structure according to any one of claims 1 to 4, wherein there is a gap between the insulating ring and the thermally conductive part.

8. The thermally conductive structure according to any one of claims 1 to 7, wherein a material of the insulating ring comprises foam, rubber, or sealant.

9. The thermally conductive structure according to any one of claims 1 to 7, wherein the insulating ring is made of a thermally conductive material.

10. The thermally conductive structure according to claim 9, wherein a material of the insulating ring comprises a thermally conductive gel, a thermally conductive insulating tape, a thermally conductive adhesive, or a thermally conductive insulating film.

11. The thermally conductive structure according to any one of claims 1 to 10, wherein a thermally conductive coefficient of the thermally conductive part is greater than or equal to 10 W/(m·K).

12. The thermally conductive structure according to any one of claims 1 to 11, wherein a material of the thermally conductive part comprises carbon fiber or graphene.

13. The thermally conductive structure according to any one of claims 1 to 12, wherein an edge shape of the thermally conductive part is the same as an inner edge shape of the insulating ring.

14. An electronic device, comprising a heating component, a heat sink, and the thermally conductive structure according to any one of claims 1 to 13, wherein the thermally conductive structure is disposed between the heating component and the heat sink.

15. The electronic device according to claim 14, wherein one side of an insulating ring is disposed in contact with the heating component, and the other side is disposed in contact with the heat sink.

16. The electronic device according to claim 14 or 15, wherein the heating component is disposed on a circuit board, one side of the insulating ring is disposed in contact with the circuit board, and the other side is disposed in contact with the heat sink.

17. The electronic device according to any one of claims 14 to 16, wherein the electronic device is a vehicle-mounted electronic device.

18. A terminal, wherein the terminal comprises the electronic device according to any one of claims 14 to 17.
